Europäisches Patentamt

European Patent Office

Office européen des brevets

(19)

(11) Publication number: **0 071 310**
A2

# EUROPEAN PATENT APPLICATION

(12)

(21) Application number: 82200935.3

(22) Date of filing: 22.07.82

(51) Int. Cl.³: **H 03 K 5/153**

(30) Priority: 31.07.81 GB 8123481

(43) Date of publication of application:
09.02.83 Bulletin 83/6

(84) Designated Contracting States:
DE FR GB IT

(71) Applicant: PHILIPS ELECTRONIC AND ASSOCIATED
INDUSTRIES LIMITED
Arundel Great Court 8 Arundel Street
London WC2R 3DT(GB)

(84) Designated Contracting States:
GB

(71) Applicant: N.V. Philips' Gloeilampenfabrieken
Groenewoudseweg 1
NL-5621 BA Eindhoven(NL)

(84) Designated Contracting States:
DE FR IT

(72) Inventor: Seth, Siya Vallabh
C/O MULLARD LIMITED New Road
Mitcham Surrey CR4 4XY(GB)

(72) Inventor: Keulemans, Alexander Hendrik Francis
13 Palmer Close
Horley Surrey(GB)

(74) Representative: Boxall, Robin John et al,
Philips Electronic and Associated Ind. Ltd. Patent
Department Mullard House Torrington Place
London WC1E 7HD(GB)

(54) Tachogenerator output signal processor.

(57) The processor includes a first voltage comparator 4 which responds to a first output voltage level of a tachogenerator 1 to provide a signal A which is present for substantially the whole of every half cycle of one polarity. This signal causes a latch, comprising an AND-gate 8 and a clocked D-type flip-flop 7, to be set to one of its two states by the signal A. A second voltage comparator 5 gives an output signal B in response to a voltage in each half cycle of the other polarity which equals or exceeds half the peak voltage of the tachogenerator concerned when operating at its predetermined minimum peak voltage output. The latch can only be set to its second state by signal B and an output pulse can only be given by the processor whilst the latch is in its second state.

Fig.1.

## "TACHOGENERATOR OUTPUT SIGNAL PROCESSOR"

This invention relates to a tachogenerator output signal processor for processing the a.c. output of a tachogenerator to provide at least one output pulse for each complete cycle of said output or an integral multiple thereof, the processor including voltage comparators each of which is arranged to respond to a respective voltage level of the said a.c. output, and logic means for combining the outputs of the voltage comparators to provide said output pulse(s).

In so-called zero crossing processors, it is known to provide a first comparator having a d.c. reference voltage level which is very slightly positive with respect to the mains zero voltage and a second comparator having a d.c. reference voltage level which is slightly negative with respect to the zero voltage. The combining means comprise logic gates which provide an output signal only while the a.c. voltage level lies between the two d.c. reference voltages.

Such processors suffer from two main disadvantages. In order to provide an output pulse substantially coincident with the instant at which the a.c. voltage crosses through zero, the two reference voltages are very close to the zero level and it is very difficult to maintain these voltages accurately. More important, however, is the fact that, due to the very low reference voltages used, these processors are very sensitive to any noise which occurs in the region of the zero crossings. Thus the output signal suffers from timing variations, usually referred to as "jitter", if there is any noise present. Noise is almost invariably present in the output of a tachogenerator, however, due _inter alia_ to magnetic field variations in the motor to which the tachogenerator is attached and also to motor commutation noise. The former type of noise is more prevalent at low motor speeds, for example during the run up to the required speed, due to the high currents flowing in the motor windings. The commutation noise becomes more prevalent at the higher speeds.

A tachogenerator processor of the type defined in the opening paragraph and in which the zero crossing points are detected as described above but which gives one output pulse for every two complete cycles of the a.c. voltage is known from U.K. Patent Specification No. 1,510,943. In order to reduce the effects of noise, four reference voltage levels (two positive and two negative) and four comparators are used in a voltage level detection means which forms the basic processor. It is shown therein that a noise pulse in a negative half cycle can cause jitter which takes a further tachogenerator cycle to settle and in which a noise pulse in a positive half cycle can cause jitter in the output which takes two periods of the tachogenerator voltage to settle down. Even this reduction of the effects of noise is achieved by the additional use of a voltage ramp generator and a further comparator.

It is an object of the invention to provide a tachogenerator which has an increased immunity to noise and which comprises a considerably simpler circuit which uses only two voltage comparators.

According to the invention, there is provided a tachogenerator process of the type defined, characterised in that the processor includes a first said voltage comparator which responds to a voltage level of the a.c. voltage which lies between substantially zero and three quarters of the peak voltage of every half cycle of the a.c. voltage of one polarity, which peak voltage is that generated by the particular tachogenerator concerned when running at said minimum speed, and a second voltage comparator which responds to a voltage level of the a.c. voltage which lies between one third and three quarters of the peak voltage in every half cycle of the other polarity; the gating means including a two-state latch which is latchable to one of its two states solely by the output signal of the first comparator and is latchable to the other of its states solely by the output signal of the second voltage comparator, the gating means further including means for _____

enabling said output pulse to be given only during the period
the latch is in its second state.

The principle of operation is that the latch is set to one
of its states by a signal from the first comparator during those
half cycles of one polarity (e.g. negative) in which no output
pulse is to be given and is set to the other of its two states
by the signal from the second comparator during the other half
cycles (e.g. positive) in which an output pulse is to be given.
The fact that the latch can only be set to one state by one of
the signals and can only be set to the other state by the other
signal results in that any noise pulse must pass through both
comparator voltage levels to result in any interference and
these voltage levels are set fairly wide apart.

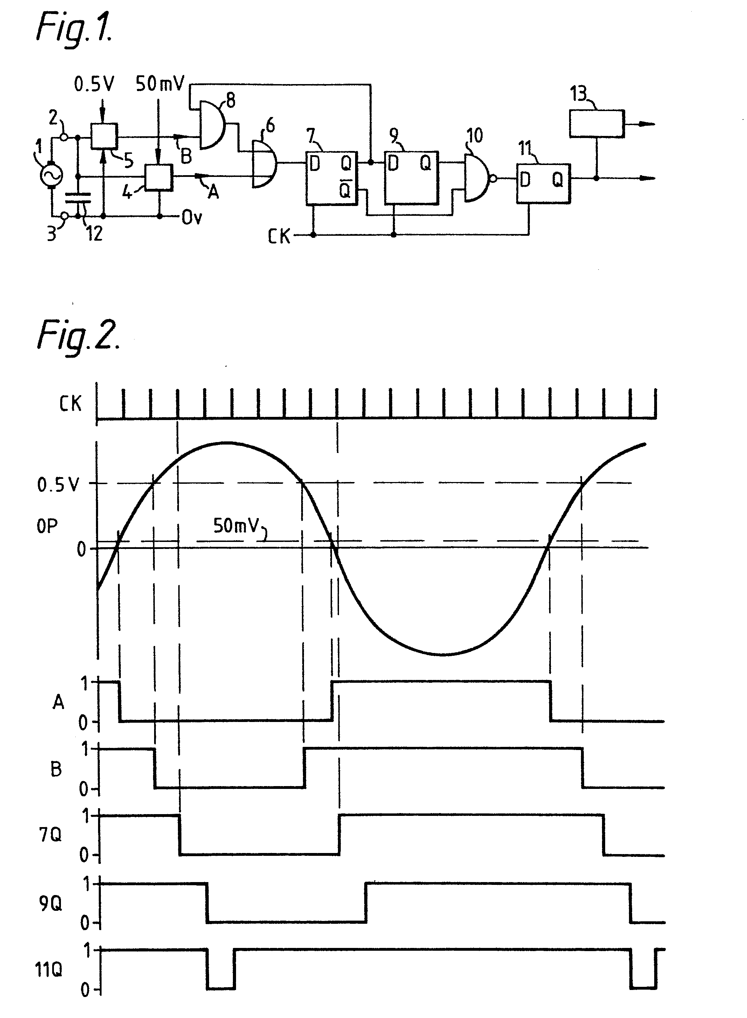

An embodiment of the invention will now be described with
reference to the accompanying drawing, Figure 1 of which shows
a circuit diagram of a processor and Figure 2 shows waveforms
occurring in various parts of the circuit.

Referring now to Figure 1, the processor is connected to a
tachogenerator 1 via terminals 2 and 3. Terminal 2 is connected to
the voltage sensing input of a first voltage level comparator 4
and a second voltage level comparator 5. Comparator 4 has a +50 mV
d.c. comparison voltage input and provides a logic output signal
A = 1 if the voltage at terminal 2 is more negative than +50 mV with
respect to the zero volt rail connected to terminal 2 and to the
two comparators. Comparator 5 has a 0.5 V d.c. comparison voltage
input and provides a logic output signal B = 1 when the voltage
at terminal 2 equals or is more positive than +0.5 V.

The output A of comparator 4 is connected to one input of an
OR-gate 6 the output of which is connected to the D input of a
delay-type flip-flop 7. The output B of comparator 5 is connected
to one input of an AND-gate 8 the other input of which is connected
to the Q output of flip-flop 7, which Q output is also connected
to the D input of a further delay-type flip-flop 9. The output
of AND-gate 8 is connected to the other input of gate 8. The Q
output of flip-flop 9 is connected to one input of NAND-gate 10

**0071310**

the other input of which is connected to the $\overline{Q}$ output of flip-flop 7. The output of gate 10 is connected to the D input of a third delay-type flip-flop 11 whose Q output constitutes the processor output.

Flip-flops 7, 9, and 11 are each fed with clock pulses CK having a pulse repetition rate, for example 80 kHz, considerably greater than the highest frequency output of tachogenerator 1 under working conditions.

The feedback connection between the Q output and the D input of flip-flop 7 via gate 8 forms a latch for the flip-flop.

The operation of the circuit will now be described with reference to Figure 2 which shows the various waveforms in the circuit under operating conditions. In Figure 2, waveform OP is the output voltage waveform of tachogenerator 9 and the 50 mV and 0.5 V comparator levels are also shown. The remaining waveforms have logic 1 or 0 values and are designated in a corresponding manner to the circuit point concerned; that is to say that, for example, the waveform at the Q output of flip-flop 7 is designated 7Q in the drawing and in the following description.

It is to be noted that the change of state of the delay flip-flops 7, 9, and 11 is effected by the next subsequent clock pulse to the instant of the last change of state of the D input. Further, the repetition frequency of the clock pulses is too high in relation to the frequency of waveform OP to be shown on the same time scale. These clock pulses are therefore shown with a very considerably reduced frequency so that the sequence of operations may be clear.

Waveform A is a 1 for the whole period of every negative going half cycle of waveform OP and therefore 7D = 1 via gate 6. The first clock pulse after A goes to 1 (written A $\longrightarrow$ 1 hereinafter) causes flip-flop 7Q $\longrightarrow$ 1 and hence at the next clock pulse 9Q $\longrightarrow$ 1. Since $7\overline{Q}$ = 0 and 9Q = 1, the output of gate 10 = 1 and 11Q $\longrightarrow$ 1 at the next clock pulse.

Since B = 1 and 7Q = 1, gate 8 is enabled and its 1 output fed to 7D via gate 6 latches flip-flop 7 to the Q = 1 state until such time as B $\longrightarrow$ 0 during the positive half cycle. Thus once A = 1 has latched flip-flop 7 to Q = 1, the state of signal A is no longer relevant and, irrespective of how much this signal may be affected by noise, the circuit remains latched for the whole of every negative-going half cycle unless a particularly large voltage noise spike exceeds the +0.5 volt level and causes B ———➤ 0. Such large spikes are relatively rare and are largely quenched by a capacitor 12 (220 nF) across terminals 2 and 3.

When the voltage OP rises to +0.5 mV, comparator 5 provides a B ———➤ 0 output. This causes 7D ———➤ 0 and, at the next clock pulse, 7Q ———➤ 0. One further clock pulse later flip-flop 11 responds to the 0 output of gate 10 one pulse earlier and 11Q ———➤ 0 to provide the leading edge of a processor output pulse. This same further clock pulse causes 9Q ———➤ 0, in response to which 11Q ———➤ 1 one clock pulse later. Thus an output pulse is generated having a width of $12\frac{1}{2}$ microseconds assuming an 80 kHz clock rate.

Since flip-flop 7 is now latched to 7Q = 0 via gate 8 (now B = 0), the circuit is completely stable until B ———➤ 1 again, i.e. towards the end of the positive half cycle as mentioned above. Thus once flip-flop 7 has latched to 7Q = 0, the processor is again immune to any noise unless a negative-going noise spike crosses both voltage levels.

From the foregoing it can be seen that the processor is only subject to noise which crosses both voltage levels except for the short period between A ———➤ 0 and B ———➤ 0 at the beginning of the positive going half cycle. This latter noise, however, would still have to have a positive-going peak of at least 0.5 V in order to cause B ———➤ 0 earlier than required. This is a very considerable improvement on zero crossing systems described in the preamble which "sense" the voltage at two levels very close to zero.

If a noise peak does happen to cause B ———➤ 0 a little earlier, then the processor output pulse might be given a little earlier by one or more clock pulse periods. However, any jitter in one output pulse has no effect on the output pulse given during the next following cycle. This, of course, is an improvement on the processor described in the aforementioned patent specification.

From the foregoing it is evident that, since any noise spike must transcend both comparator voltage levels to interfere with the operation of the latch formed by flip-flop 7 and gate 8 and also that in many cases such interference will not result in any jitter or additional output pulses. Thus the noise immunity can be increased by increasing the voltage gap between the two levels. The value of +50 mV is, for present purposes, to be regarded as substantially zero voltage since it is so close thereto as to have no significant difference. This value has been chosen in the described embodiment to show one limit for this voltage, namely the worst case. In accordance with the invention, this voltage is between substantially zero (+50 mV) and three quarters of the negative peak voltage generated by the tachogenerator when running at its minimum speed (and hence minimum voltage) in the predetermined speed range over which the tachogenerator is used in practice. Using the example of waveform OP given in Figure 2, the peak output voltage is 0.75 volt and the most negative voltage level for comparator 4 would thus be approximately 0.56 volt. This, of course, means that any noise pulses capable of causing interference would have to be more than twice as large as those that could interfere in the case of Figure 2. The reference voltage should be sufficiently less than the a.c. minimum peak value to ensure that signal A sets the latch to 1 safely, that is to say that the a.c. voltage exceeds the reference level for a greater time than the duration of at least most noise pulses which might otherwise mask it.

In a similar way, the minimum reference level for comparator 4 should be high enough to give good noise immunity but must not be so close to the minimum peak voltage that it can be masked by noise. Accordingly a range of one third to three quarters of the peak value is suitable, the optimum being about two thirds of the peak value in each case.

In systems using a processor, it is sometimes convenient to divide the output pulse repetition rate by a divider 12 such

**0071310**

that a single pulse is given for each two or more complete cycles of the tachogenerator a.c. output. This has the advantage that the period between the output pulses is increased and, therefore, any jitter of the pulses due to noise is a relatively smaller portion of the periods between them and, therefore, the effects of noise are reduced by the division ratio.

In the embodiment described above, the output pulse is provided in the positive-going half cycles. The negative half cycles could, of course, equally well be used.

It is useful in some control systems to provide more than one pulse for each complete cycle of the a.c. waveform. Such extra pulses can readily be provided by further delay-type flip-flops. Alternatively, the output of $9Q = 0$ or $11Q = 0$ could be used to trigger a counter to provide any required number of pulses for each cycle. Such arrangements are well known in the art.

0071310

CLAIMS:

1.    A tachogenerator output signal processor for processing the a.c. output of a tachogenerator when running at or above a given minimum speed to provide at least one output pulse for each complete cycle of said output or an integral multiple thereof, the processor including voltage comparators each of which is arranged to respond to a respective predetermined voltage level of the said a.c. output, and logic means for combining the outputs of the voltage comparators to provide said pulse(s), characterised in that the processor includes a first said voltage comparator which responds to a voltage level of the a.c. voltage which lies between substantially zero and three quarters of the peak voltage of every half cycle of the a.c. voltage of one polarity, which peak voltage is that generated by the particular tachogenerator concerned when running at said minimum speed, and a second voltage comparator which responds to a voltage level of the a.c. voltage which lies between one third and three quarters of the peak voltage in every half cycle of the other polarity; the gating means including a two-state latch which is latchable to one of its two states solely by the output signal of the first comparator and is latchable to the other of its states solely by the output signal of the second voltage comparator, the gating means further including means for enabling said output pulse to be given only during the period the latch is in its second state.

2.    A processor as claimed in Claim 1, characterised in that said latch comprises a logic gate and a delay-type flip-flop having an output connected to an input of the gate to provide a feedback latching path.

3.　　A processor as claimed in any previous Claim and a divider connected to the pulse output of the processor.

**Fig.1.**

**Fig.2.**